# EUROPÄISCHE PATENTSCHRIFT

(11) **EP 1 521 713 B1**
(45) Veröffentlichungstag und Bekanntmachung des Hinweises auf die Patenterteilung: **27.08.2014**
(21) Anmeldenummer: 03764906.8
(22) Anmeldetag: 17.07.2003
(51) Int. Cl.: B65G 49/06, C03B 35/00, C03B 17/06, C03C 17/32, C03C 17/06, C03C 17/00, B32B 17/06

(54) **BRUCHSICHERES ULTRA DÜNNES GLAS UND DESSEN HANDHABUNG**
SHATTERPROOF ULTRA-THIN GLASS AND THE HANDLING THEREOF
VERRE ULTRAFIN INCASSABLE ET SON MANIEMENT

(30) Priorität: 17.07.2002 DE 10232453
(43) Veröffentlichungstag der Anmeldung: 13.04.2005
(73) Patentinhaber: OSRAM Opto Semiconductors GmbH, 93055 Regensburg (DE)
(72) Erfinder: HENSELER, Debora, 91052 Erlangen (DE); HEUSER, Karsten, 91056 Erlangen (DE); WITTMANN, Georg, 91074 Herzogenaurach (DE); PÄTZOLD, Ralph, 91154 Roth (DE)
(74) Vertreter: Epping - Hermann - Fischer
(86) Internationale Anmeldenummer: PCT/DE2003/002413
(87) Internationale Veröffentlichungsnummer: WO 2004/009480

(56) Entgegenhaltungen:
- EP-A- 0 845 427
- EP-A- 1 029 831
- WO-A-01/83180
- DE-A- 10 040 640
- DE-A- 19 810 325
- DE-C- 19 914 601
- US-A- 5 073 181
- US-A1- 2002 053 121
- US-B1- 6 309 901

## Beschreibung

Die Erfindung betrifft ein dünnes oder ultra dünnes Glas (der Ausdruck "ultra dünn" umfasst im folgenden sowohl dünne als auch ultra dünne Gläser), also ein Glas einer maximalen Dicke von 200µm, das stabilisiert ist und Verwendungen davon.

Ultra dünne Gläser werden vor allem in der Elektrotechnik als Substrate eingesetzt. Insbesondere bei der Herstellung von besonders leichten oder platzsparenden oder flexiblen Elektronik-Bauteilen oder formbaren Displays, z.B. auf OLED- oder LCD-Technologie basierend, sind die ultra dünnen Gläser flexible und chemisch äußert widerstandsfähige Substrate, die bevorzugt eingesetzt werden.

Jedoch haben diese dünnsten Gläser einen entscheidenden Nachteil, der allen Gläsern gemeinsam ist: Sie sind spröde und brechen leicht, insbesondere nach erfolgter Beschädigung an den Kanten.

Zur Stabilisierung werden die ultra dünnen Gläser, die dank ihrer "Dicke" für Gläser bereits recht flexibel und biegsam sind, mit einer stabilisierenden Beschichtung, vorzugsweise einer Polymerschicht überzogen, die das Glas sozusagen von hinten verklebt. Diese Stabilisierung reicht jedoch in vielen Fällen, wie z.B. beim Einsatz der ultra dünnen Gläser in bestehenden Produktionsstrassen, nicht aus. Die Folge ist einerseits, dass die Gläser brechen und eine hohe Ausfallrate zeigen, andererseits, dass ein hoher Reinigungs- und Wartungsaufwand nach einem Dünnglasbruch in den Produktionsstraßen notwendig ist.

Die Druckschrift EP 1 029 831 beschreibt ein Verfahren zur Herstellung eines Bauteiles wie beispielsweise eines OLED-Displays, wobei als Substrat ein Laminat verwendet wird, das einen Träger und eine Glasschicht mit einer Dicke unter 700 µm umfasst, die beispielsweise durch Kleben oder Vakuumlamination verbunden sein können.

Die Druckschrift 100 40 640 offenbart ein Verfahren und eine Vorrichtung zur Herstellung von Einzelglasscheiben mit geringer Dicke und sehr hoher Oberflächenqualität zum Einsatz in elektronischen Geräten wie beispielsweise Telefonen oder Flachbildschirmen. Um derartige Einzelglasscheiben in hinreichender Qualität wirtschaftlich herstellen zu können, wird vorgeschlagen, unmittelbar nach Ziehen des Glasbandes dieses in einer Beschichtungseinrichtung mit einer Schutzschicht, beispielsweise aus Polyvinylalkohol, zu versehen.

In der Druckschrift WO 01/83180 wird ein Verfahren zum Bearbeiten von Glasscheiben beschrieben, bei dem die zu bearbeitenden Glasscheiben als Stapel mit jeweils wenigstens einer Zwischenlage gepackt werden, der Stapel bearbeitet wird und der Stapel durch Entfernen jeweils wenigstens einer Zwischenlage gelöst wird.

Die Druckschrift US 6,309,901 beschreibt ein Verfahren zum Schutz einer Glasoberfläche, insbesondere bei der thermischen Behandlung eines Stapels von Glasplättchen. Hierzu werden Partikel mit einem Durchmesser <100 µm zumindest auf einer von zwei im Stapel aneinander liegenden Glasoberflächen aufgebracht.

Aufgabe der Erfindung ist es daher, ein ultra dünnes Glas zu schaffen, das so stabilisiert ist, dass es transportiert und in bestehende Produktionsstrassen eingesetzt werden kann. Des weiteren ist es Aufgabe der Erfindung Verwendungen dieses Glases anzugeben.

Gegenstand der Erfindung ist eine Vorrichtung mit einem ultra dünnem Glas und einem stabilen Träger. Dabei weist das ultra dünne Glas eine Dicke von nicht mehr als 200 µm auf und ist mit einem stabilen Träger lösbar verbunden. Die Verbindung kann durch punktuelle Fixierung mittels miniaturisierter Saugknöpfe hergestellt werden. Alternativ hierzu kann das ultradünne Glassubstrat an dem mechanisch stabilen Träger magnetisch fixiert oder mittels flüssigen Glas oder Glaslot punktuell verbunden sein.
Fixiert man die zu verarbeitenden Substrate (dünne und ultra dünne Gläser) mittels einer lösbaren, also reversibel knüpfbaren, Kontaktierung auf einem stabilen Träger, der vergleichbare chemische und/oder physikalische Eigenschaften haben kann, so kann eine bestehende Fabrikationstechnik für beispielsweise eine OLED Produktion mit einem nicht flexiblen also nicht ultra dünnen Glassubstrat, ohne Anpassung, genutzt und der Ausschuss minimiert werden. Das vorgeschlagene System mit einem stabilen Träger kann entweder ab der Produktion des Glases bis hin zum Endprodukt durchgängig verwendet werden, oder für einzelne Produktionsschritte geeignet variabel eingesetzt und benutzt werden. So kann beispielsweise ein stabiler Träger das ultra dünne Glas beim Transport schützen, ein weiterer, andere chemische und/oder physikalische Eigenschaften aufweisender Träger bei der Herstellung der ITO-Schicht (Indium Tin Oxide) der Organischen Leuchtdiode und ein dritter bei der Beschichtung mit Lochtransportmaterial etc.

Nach einer Ausführungsform ist das ultra dünne Glas mittels einer Verbindungsschicht auf dem Träger lösbar fixiert.

Als Verbindungsschicht kann eine beliebige Art der Verklebung und/oder Beschichtung dienen. So ist es denkbar, das ultra dünne Glas mit einer Metallschicht zu bedampfen und dann auf einem magnetischen Träger zu befestigen. Des weiteren ist es denkbar, das ultra dünne Glas mit einer Verklebungsschicht, die beispielsweise wieder ablösbar sein kann, auf dem stabilen Träger zu fixieren.

Ebenso ist denkbar, das Glas nur punktuell auf den Träger, z.B. mittels miniaturisierter Saugknöpfe, lösbar zu fixieren.

Der stabile Träger kann ein normal dickes Glas sein, so dass er ähnliche oder identische chemische und/oder physikalische Eigenschaften wie das ultra dünne Glas hat. Diese Ausführungsform ist für den Einsatz des ultra dünnen Glases in bestehende Fabrikationstechniken oder Produktionsstrassen, wo das ultra dünne Glas als Substrat für elektronische Bauteile verschiedenen Umgebungen, wie z.B. Temperatur, Lösungsmittel, Bedampfung etc. ausgesetzt ist, geeignet. Die Materialien, die sich für den Einsatz als stabile Träger eignen sind nicht begrenzt und können alle Arten metallischer, natürlicher und synthetischer, organischer und anorganischer Art umfassen.

Je nach Anwendung kann der stabile Träger in seinen Abmessungen, außer der Dicke, dem ultra dünnem Glas genau entsprechen oder über dieses hinausragen.

Es wird weiterhin ein Verfahren zur Herstellung eines elektronischen Bauteils angegeben. In einem Verfahrensschritt wird ein ultra dünnes Glas mit einer Dicke von nicht mehr als 200 µm an einen mechanisch stabilen Träger derart fixiert, dass dieser wieder entfernt werden kann. In einem anderen Verfahrensschritt wird ein elektronisches Bauteil auf dem Glassubstrat hergestellt. Die reversible Verbindung des ultradünnen Glassubstrats mit dem stabilen Träger kann durch punktuelle Fixierung mittels miniaturisierter Saugknöpfe hergestellt werden. Alternativ hierzu kann das ultradünne Glassubstrat magnetisch an den mechanisch stabilen Träger fixiert oder mittels flüssigen Glas oder Glaslot punktuell mit diesem verbunden sein.

Der stabile Träger kann aber darüber hinaus auch gewechselt werden, so kann ein stabiler Träger aus Metall, an den das ultra dünne Glas während des Transports fixiert ist, durch einen gläsernen stabilen Träger, der das ultra dünne Glas durch die Fabrikationsstrasse begleitet, ausgetauscht werden.

Dies umso mehr, als beispielsweise das ultra dünne Glas mehrere Fabrikationsschritte an verschiedenen Orten durchlaufen muss. Hier kann ein stabiler Träger für den Transport sich mit einem oder mehreren stabilen Trägern, die speziell in den Produktionsstrassen eingesetzt werden, abwechseln. Dabei sind die Anforderungen an den stabilen Träger voneinander verschieden und so kann ein stabiler Träger, der zum Transport dient, über die Kanten des ultra dünnen Glases hinausragen während ein anderer stabiler Träger, der das ultra dünne Glas während der Produktion stützt, in den Abmessungen dem ultra dünnen Glas genau entspricht, damit er in bestehende Formen und Strukturen zur Bearbeitung passt.

Auch die Anforderungen an die chemischen und physikalischen Eigenschaften des stabilen Trägers können ganz verschieden ausfallen, so dass einerseits ein stabiler Träger einen gleichen thermischen Ausdehnungskoeffizienten und gleiche chemische Reaktivität haben sollte und andererseits beim Lösen des stabilen Trägers, also beim Trennen des fertig beschichteten und/oder sich am Zielort befindenden ultra dünnen Glases vom stabilen Träger sollte es Mittel geben, die den Träger ablösen oder auflösen und das ultra dünne Glas, gegebenenfalls mit Schichtaufbau unversehrt lassen. Mittel zum Lösen oder Fixieren sind dabei alle Arten der Bestrahlung (UV; IR; Microwellen etc.), Beschichtung, Verklebung, magnetische Fixierung, Einsatz von gasförmigen, flüssigen oder festen Lösungsmitteln, Gelen, Netzen, Gittern oder auch mechanische Einwirkungen, die durchaus zerstörerische Wirkung auf den Träger besitzen können.

Der stabile Träger ist beispielsweise über eine Verbindungsschicht mit dem ultra dünnen Glas verbunden. Das Fixieren und/oder das Abtrennen des stabilen Trägers kann dabei auch über UV-Bestrahlung, Lösungsmittelanwendung, Microwellenbestrahlung oder anderes stattfinden. Die Anforderungen an die Verbindungsschicht sind je nach Einsatz verschieden, so kann eine Verbindungsschicht die gewünschte Fixierung des ultra dünnen Glases ermöglichen (wie z.B. bei der Metallbedampfung und der Fixierung auf einen magnetischen stabilen Träger) oder eine Verklebung sein, die das ultra dünne Glas mit einem dickeren Glas oder Kunststoff zumindest temporär verklebt.

Weiterhin besteht die Möglichkeit, das Substrat und den Träger als ein Produkt herzustellen. Besonders vorteilhaft ist hier die Ausführung, zwei Gläser, hier Dünnglas und Träger, während der Produktion, also noch im nicht erstarrten Zustand, mittels flüssigem Glas oder Glaslot, punktuell zu verbinden. Vorteilhafterweise wird das ultra dünne Glas gleich nach seiner Herstellung oder Produktion auf einen stabilen Träger fixiert, bleibt dann während der ganzen Dauer seiner Verarbeitung als Substrat eines elektronischen Elements und seines Transports zu den verschiedenen Verarbeitungsstätten auf einem stabilem Träger fixiert. Dabei muss der Träger nicht immer der gleiche bleiben, sondern es kann sich durchaus um verschiedene Träger handeln. Das ultra dünne Glassubstrat wird nach einer Ausführungsform erst wieder nach der fertigen Verkapselung des elektronischen Elements direkt vor seinem Einbau in ein elektronisches Bauteil von dem (letzten) stabilen Träger gelöst. Sobald das ultra dünne Glas wieder abgelöst ist, hat es beispielsweise wieder seine gewünschte Flexibilität und/oder ursprünglichen Eigenschaften.

Als elektronisches Element wird hier beispielsweise eine fertig verkapselte OLED auf einem Substrat aus ultra dünnem Glas bezeichnet, die in ein elektronisches Bauteil, wie z.B. einen Photodetektor eingebaut wird.

Natürlich kann die Ablösung vom stabilen Träger an jeder Stelle der Verarbeitung des ultra dünnen Glases stattfinden.

Für den Fall, dass der stabile Träger nicht mehr vollständig vom ultra dünnen Glas gelöst werden kann, kann ein relevanter Bereich des ultra dünnen Glases, beispielsweise durch Glasschneiden, herausgetrennt werden.

Flexible Elektronik-Bauteile, die auf oder zwischen ultra dünnes Glas gefertigt werden, sind beispielsweise Solarzellen oder Photodetektoren, Organische Licht emittierende Dioden (OLEDs), Displays oder ähnliche Anwendungen, bei denen bevorzugt eine Seite des elektronischen Bauteils transparent ist.

Die hier beschriebene Erfindung schildert erstmals ein Konzept Dünnglas und Ultradünnglas (Glas mit einer Dicke, die 200µm nicht übersteigt) über eine lösbare Verbindung mit einem stabilen Träger handzuhaben und zu verarbeiten, wobei die bestehenden Aufbauten für herkömmliches Glas weitergenutzt werden können. Dünnglas ist ein interessantes Substratmaterial, das es erlaubt, dünne leichte und auch flexible Anwendungen zu realisieren. Einzig die fehlende Möglichkeit diese Gläser, wegen ihrer hohen Zerbrechlichkeit, zu transportieren, zu reinigen und zu verarbeiten, verhinderte bislang die großflächige Markteinführung.

## Patentansprüche

1. Vorrichtung mit:
- ultra dünnem Glas mit einer Dicke von nicht mehr als 200 µm, und
- einem stabilen Träger, wobei das ultradünne Glas und der stabile Träger lösbar miteinander verbunden sind,
**dadurch gekennzeichnet, dass**
das ultradünne Glassubstrat an dem stabilen Träger mittels miniaturisierter Saugknöpfe punktuell fixiert ist, oder
das ultradünne Glassubstrat an dem mechanisch stabilen Träger magnetisch fixiert ist, oder
das ultradünne Glassubstrat an dem mechanisch stabilen Träger mittels flüssigem Glas oder Glaslot punktuell verbunden ist.

2. Vorrichtung nach Anspruch 1,
**dadurch gekennzeichnet, dass**
der stabile Träger in chemischen und/oder physikalischen Eigenschaften dem ultra dünnen Glas angeglichen ist.

3. Vorrichtung nach einem der Ansprüche 1 oder 2
**dadurch gekennzeichnet, dass**
der stabile Träger in den Abmessungen, außer der Dicke, genau dem ultra dünnen Glas entspricht oder über dieses hinausragt.

4. Vorrichtung nach einem der Ansprüche 1 bis 3
**dadurch gekennzeichnet, dass**
der stabile Träger aus Glas oder Metall ist.

5. Vorrichtung nach einem der Ansprüche 1 bis 4
**dadurch gekennzeichnet, dass**
sie ein OLED-Bauteil umfasst.

6. Verfahren zur Herstellung eines elektronischen Bauteils mit den Schritten:
- Fixieren eines ultra-dünnen Glassubstrates mit einer Dicke kleiner oder gleich 200 µm an einem mechanisch stabilen Träger, derart, dass der mechanisch stabile Träger wieder entfernt werden kann; und
- Herstellen eines elektronischen Bauteils auf dem ultra-dünnen Glassubstrat;
**dadurch gekennzeichnet, dass**
das ultradünne Glassubstrat an dem mechanisch stabilen Träger mittels miniaturisierter Saugknöpfe punktuell fixiert wird, oder
das ultradünne Glassubstrat an dem mechanisch stabilen Träger magnetisch fixiert wird, oder
das ultradünne Glassubstrat an dem mechanisch stabilen Träger mittels flüssigem Glas oder Glaslot punktuell verbunden wird.

7. Verfahren nach Anspruch 6,
**dadurch gekennzeichnet, dass**
das ultra-dünne Glassubstrat zur magnetischen Fixierung mit einer Metallschicht versehen ist.

8. Verfahren nach einem der Ansprüche 6 bis 7,
**dadurch gekennzeichnet, dass** der mechanisch stabile Träger gewechselt wird.

9. Verfahren nach Anspruch 8,
**dadurch gekennzeichnet, dass**
der mechanisch stabile Träger aus Metall ist und durch einen gläsernen stabilen Träger ausgetauscht wird.

10. Verfahren nach einem der Ansprüche 7 oder 8,
**dadurch gekennzeichnet, dass**
das ultra-dünne Glassubstrat mit Hilfe einer Verbindungsschicht an dem mechanisch stabilen Träger fixiert wird.

11. Verfahren nach Anspruch 10,
**dadurch gekennzeichnet, dass**
die Verbindungsschicht eine Verklebung ist.

12. Verfahren nach einem der Ansprüche 6 bis 11,
**dadurch gekennzeichnet, dass**
der stabile Träger über die Kanten des ultra-dünnen Glassubstrates hinausragt.

13. Verfahren nach einem der Ansprüche 6 bis 11,
**dadurch gekennzeichnet, dass**
der stabile Träger in den Abmessungen dem ultra-dünnen Glassubstrat entspricht.

14. Verfahren nach einem der Ansprüche 6 bis 13,
**dadurch gekennzeichnet, dass**
der letzte mechanische Träger von dem ultra-dünnen Glassubstrat wieder entfernt wird.

15. Verfahren nach einem Ansprüche 6 bis 14,
**dadurch gekennzeichnet, dass** die Herstellung des elektronischen Bauteils die Herstellung eines OLED-Bauteils beinhaltet.

## Claims

1. Apparatus having:
- ultra-thin glass with a thickness of not more than 200 µm, and
- a stable carrier, the ultra-thin glass and the stable carrier being connected to one another releasably,
**characterized in that**
the ultra-thin glass substrate is fixed on the stable carrier in a punctiform manner by means of miniaturized suction studs, or
the ultra-thin glass substrate is fixed magnetically on the mechanically stable carrier, or
the ultra-thin glass substrate is connected on the mechanically stable carrier in a punctiform manner by means of molten glass or glass solder.

2. Apparatus according to Claim 1, **characterized in that** the stable carrier is adapted to the ultra-thin glass in terms of chemical and/or physical properties.

3. Apparatus according to either of Claims 1 and 2, **characterized in that** the stable carrier corresponds precisely to the ultra-thin glass in terms of the dimensions, except the thickness, or protrudes beyond the said ultra-thin glass.

4. Apparatus according to one of Claims 1 to 3, **characterized in that** the stable carrier is made from glass or metal.

5. Apparatus according to one of Claims 1 to 4, **characterized in that** it comprises an OLED component.

6. Method for producing an electronic component having the steps:
- fixing of an ultra-thin glass substrate with a thickness of less than or equal to 200 µm on a mechanically stable carrier, in such a way that the mechanically stable carrier can be removed again; and
- production of an electronic component on the ultra-thin glass substrate;
**characterized in that**
the ultra-thin glass substrate is fixed on the mechanically stable carrier in a punctiform manner by means of miniaturized suction studs, or
the ultra-thin glass substrate is fixed magnetically on the mechanically stable carrier, or
the ultra-thin glass substrate is connected on the mechanically stable carrier in a punctiform manner by means of molten glass or glass solder.

7. Method according to Claim 6, **characterized in that** the ultra-thin glass substrate is provided with a metal layer for magnetic fixing.

8. Method according to either of Claims 6 and 7, **characterized in that** the mechanically stable carrier is changed.

9. Method according to Claim 8, **characterized in that** the mechanically stable carrier is made from metal and is replaced by a glass stable carrier.

10. Method according to either of Claims 7 and 8, **characterized in that** the ultra-thin glass substrate is fixed on the mechanically stable carrier with the aid of a connecting layer.

11. Method according to Claim 10, **characterized in that** the connecting layer is an adhesive.

12. Method according to one of Claims 6 to 11, **characterized in that** the stable carrier protrudes beyond the edges of the ultra-thin glass substrate.

13. Method according to one of Claims 6 to 11, **characterized in that** the stable carrier corresponds in terms of the dimensions to the ultra-thin glass substrate.

14. Method according to one of Claims 6 to 13, **characterized in that** the last mechanical carrier is removed again from the ultra-thin glass substrate.

15. Method according to one of Claims 6 to 14, **characterized in that** the production of the electronic component comprises the production of an OLED component.

## Revendications

1. Dispositif présentant :
un verre ultra mince d'une épaisseur non supérieure à 200 µm et
un support stable, le verre ultramince et le support stable étant reliés l'un à l'autre de manière libérable,
**caractérisé en ce que**
le substrat en verre ultramince est fixé par points sur le support stable au moyen de ventouses miniaturisées ou
**en ce que** le substrat en verre ultramince est fixé sur le support mécaniquement stable par des moyens magnétiques ou
**en ce que** le support en verre ultramince est relié par points au support mécaniquement stable au moyen de verre liquide ou de brasure de verre.

2. Dispositif selon la revendication 1, **caractérisé en ce que** le support stable présente des propriétés chimiques et/ou des propriétés physiques comparables à celles du verre ultramince.

3. Dispositif selon l'une des revendications 1 ou 2, **caractérisé en ce qu'**à l'exception de l'épaisseur, les dimensions du support stable correspondent exactement à celles du verre ultramince ou débordent au-delà de ce dernier.

4. Dispositif selon l'une des revendications 1 à 3, **caractérisé en ce que** le support stable est réalisé en verre ou en métal.

5. Dispositif selon l'une des revendications 1 à 4, **caractérisé en ce qu'**il comporte un composant OLED.

6. Procédé de fabrication d'un composant électronique, le procédé comportant les étapes consistant à :
fixer un substrat en verre ultramince d'une épaisseur inférieure ou égale à 200 µm sur un support mécaniquement stable de telle sorte que le support mécaniquement stable puisse en être retiré et
préparer un composant électronique sur le substrat en verre ultramince,
**caractérisé en ce que**
le substrat en verre ultramince est fixé par points sur le support stable au moyen de ventouses miniaturisées ou
**en ce que** le substrat en verre ultramince est fixé sur le support mécaniquement stable par des moyens magnétiques ou
**en ce que** le support en verre ultramince est relié par points au support mécaniquement stable au moyen de verre liquide ou de brasure de verre.

7. Procédé selon la revendication 6, **caractérisé en ce que** le substrat en verre ultramince est doté d'une couche métallique pour permettre sa fixation par des moyens magnétiques.

8. Procédé selon l'une des revendications 6 à 7, **caractérisé en ce que** le support mécanique stable est remplaçable.

9. Procédé selon la revendication 8, **caractérisé en ce que** le support mécaniquement stable est réalisé en métal et est remplacé par un support stable en verre.

10. Procédé selon l'une des revendications 7 ou 8, **caractérisé en ce que** le substrat en verre ultramince est fixé sur le support mécaniquement stable à l'aide d'une couche de liaison.

11. Procédé selon la revendication 10, **caractérisé en ce que** la couche de liaison est un collage.

12. Procédé selon l'une des revendications 6 à 11, **caractérisé en ce que** le support stable déborde au-delà des bords du substrat en verre ultramince.

13. Procédé selon l'une des revendications 6 à 11, **caractérisé en ce que** les dimensions du support stable correspondent à celles du substrat en verre ultramince.

14. Procédé selon l'une des revendications 6 à 13, **caractérisé en ce que** le dernier support mécanique est de nouveau retiré du substrat en verre ultramince.

15. Procédé selon l'une des revendications 6 à 14, **caractérisé en ce que** la fabrication du composant électronique comporte la fabrication d'un composant OLED.
